# EUROPÄISCHE PATENTSCHRIFT

(11) **EP 0 684 657 B1**
(45) Veröffentlichungstag und Bekanntmachung des Hinweises auf die Patenterteilung: **05.07.2000**
(21) Anmeldenummer: 95810310.3
(22) Anmeldetag: 09.05.1995
(51) Int. Cl.: H01P 1/26, G01R 29/08, G01R 29/10

(54) **TEM-Wellenleiteranordnung**
TEM waveguide device
Dispositif guide d'ondes du type TEM

(30) Priorität: 27.05.1994 DE 4418664
(43) Veröffentlichungstag der Anmeldung: 29.11.1995
(73) Patentinhaber: ABB (Schweiz) AG, 5401 Baden (CH)
(72) Erfinder: Gassmann, Felix, CH-8038 Zürich (CH); Hoitink, Henk, CH-5200 Windisch (CH); Müller, Rolf, D-8902 Urdorf (CH); Schär, Hans, Dr., CH-4059 Basel (CH)
(74) Vertreter: Clerc, Natalia

(56) Entgegenhaltungen:
- EP-A- 0 363 831
- EP-A- 0 369 273
- DE-A- 3 503 181
- DE-A- 3 931 449

## Beschreibung

### TECHNISCHES GEBIET

Bei der Erfindung wird ausgegangen von einer TEM-Wellenleiteranordnung nach dem Oberbegriff des Patentanspruchs 1.

### STAND DER TECHNIK

Mit dem Oberbegriff des Patentanspruchs 1 nimmt die Erfindung auf einen Stand der Technik Bezug, wie er aus der EP-A1-0 246 544 bekannt ist. Dort ist ein reflexionsfreier Abschluß für einen TEM-Wellenleiter angegeben, bei welchem eine TEM-Welle zwischen einem Innenleiter und einem Außenleiter geführt wird. Als Leitungsabschluß zur Absorption der leitergebundenen Energie ist ein ohmscher Widerstand vorgesehen, welcher eine graduelle, serielle Bedämpfung des Innenleiters bewirkt und einen durch HF-Absorber zur Absorption von feldgebundener Energie zusätzlich hervorgerufenen Kapazitätsbelag lokal kompensiert. Derartige TEM-Wellenleiteranordnungen bzw. -zellen dienen zur Prüfung von elektronischen Geräten auf ihre Verträglichkeit bezüglich einer äußeren Einwirkung von elektromagnetischen Feldern und zur breitbandigen Emissionsmessung. Es können definierte Feldverteilungen über einen weiten Frequenzbereich eingestellt werden.

Nachteilig ist der große Aufwand für Parallel- und Reihenschaltungen für die Abschlußwiderstände.

Aus der EP-B1-0 363 831 ist eine TEM-Wellenleiteranordnung mit einem sich pyramidenförmig aufweitenden TEM-Wellenleiter bekannt, der einen asymmetrisch angeordneten, plattenförmigen Innenleiter aufweist. Dieser ist durch eine nach Art einer Kugelkalotte gekrümmte Absorberwand mit pyramidenförmigen Hochfrequenz-Spitzenabsorbern hindurchgeführt auf eine Anzahl von Abschlußwiderständen. Für Eingangsleistungen über 1 kW läßt sich am Abschluß des Innenleiters die entstehende Wärme nicht ausreichend abführen. Die Kompensation des durch die HF-Absorber hervorgerufenen Kapazitätsbelages ist unbefriedigend. Auf Grund ihres Herstellungsverfahrens weisen die Absorber zu große Toleranzen im Bereich von ± 50 % auf.

Zum einschlägigen Stand der Technik wird zusätzlich auf einen Firmenprospekt: The Carborundum Company, Electronic Ceramics Division, P. O. Box 664, Niagara Falls, New York 14302, Form A-7049, aus dem Jahre 1981 hingewiesen, aus dem induktionsarme, rohrförmige Widerstände bekannt sind, die Temperaturen bis 230 °C oder 350 °C und Spitzenspannungen bis 5 kV vertragen.

### DARSTELLUNG DER ERFINDUNG

Die Erfindung, wie sie im Patentanspruch 1 definiert ist, löst die Aufgabe, eine TEM-Wellenleiteranordnung der eingangs genannten Art derart weiterzuentwickeln, daß sie sich für Eingangsleistungen über 1 kW eignet und bezüglich ihres Leitungsabschlusses mit geringeren Kosten realisierbar ist.

Vorteilhafte Ausgestaltungen der Erfindung sind in den abhängigen Patentansprüchen definiert.

Ein Vorteil der Erfindung besteht darin, daß viel weniger Widerstände für den Abschluß des Innenleiters benötigt werden. Damit reduziert sich der Arbeitsaufwand bei der Herstellung infolge einer geringeren Anzahl von Schweiß- oder Anschlußarbeiten. Der Platzbedarf für die Widerstände ist geringer.

Durch Einhalten eines definierten Abstandes der rohrförmigen Widerstände zu den Absorbern kann deren kapazitiver Einfluß minimiert werden.

### KURZE BESCHREIBUNG DER ZEICHNUNGEN

Die Erfindung wird nachstehend anhand von Ausführungsbeispielen erläutert. Es zeigen:
- Fig. 1: eine TEM-Wellenleiteranordnung mit Innenleiter, Abschlußwiderstand und Hochfrequenzabsorbern,
- Fig. 2 und 3: ausschnittsweise Draufsichten auf Hochfrequenzabsorber im Bereich des Innenleiters,
- Fig. 4: ausschnittsweise einen Längsschnitt durch Hochfrequenzabsorber im Bereich des Innenleiterabschlusses,
- Fig. 5: einen Querschnitt durch Hochfrequenzabsorber längs der Linie A-A in Fig. 4,
- Fig. 6: eine Stromverteilung auf dem Innenleiter gemäß Fig. 1 quer zur Ausbreitungsrichtung einer TEM-Welle,
- Fig. 7: eine Aufteilung der Stromverteilung auf dem Innenleiter gemäß Fig. 5 in Gebiete gleicher Stromdichte und
- Fig. 8 und 9: Übergangszonen des Innenleiters mit Zahnstruktur.

### WEGE ZUR AUSFÜHRUNG DER ERFINDUNG

In den Figuren sind gleiche Teile mit gleichen Bezugszeichen gekennzeichnet.

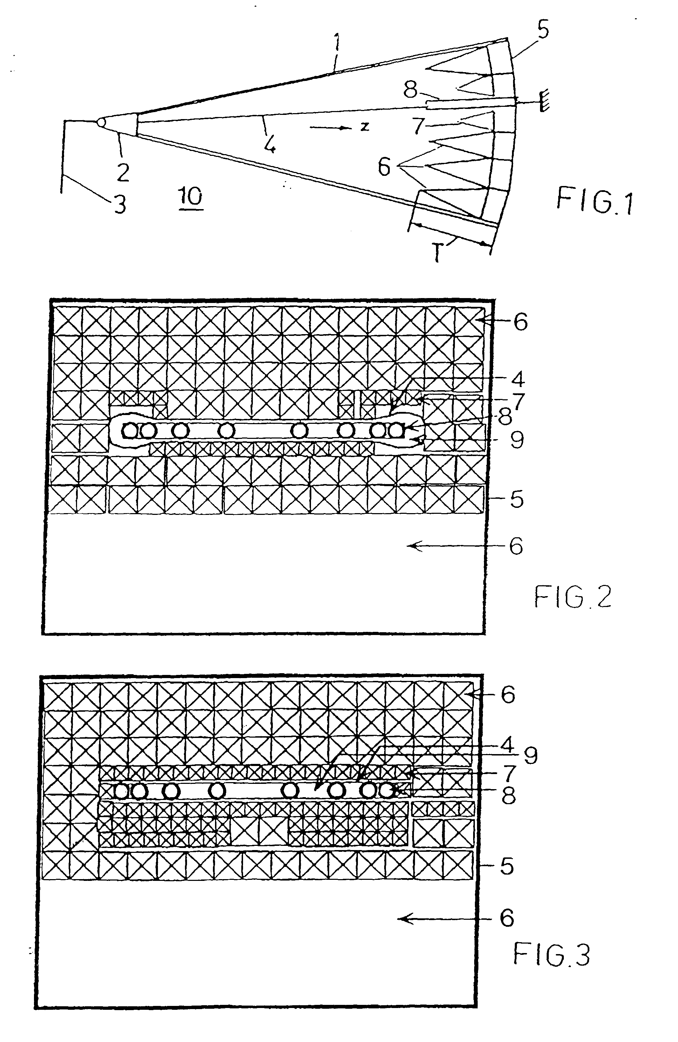

Fig. 1 zeigt die wesentlichen Teile einer TEM-Wellenleiteranordnung (10) mit einem metallischen, geerdeten, pyramidenstumpfförmigen Außenleiter (1), einer darin an nichtdargestellten Fäden asymmetrisch aufgehängten, plattenförmigen Scheidewand bzw. einem Innenleiter (4), der randseitig über einen rohrförmigen Widerstand (8) an einer Rückwand (5) geerdet ist, einem Speisekeil (2), HF-Langspitzenabsorbern (6) und dem rohrförmigen Widerstand (8) lateral benachbarten HF-Kurzspitzenabsorbern (7). Ein Koaxialkabel (3) führt dem Speisekeil (2) eine impuls- oder sinusförmige Hochfrequenzenergie (HF) zu, der eine transversale elektromagnetische sog. TEM-Welle erzeugt und in die TEM-Wellenleiteranordnung (10) einkoppelt. Mit (T) ist ein Endbereich bzw. Übergangsbereich bezeichnet, welcher durch die Länge der HF-Langspitzenabsorber (6) gegeben ist.

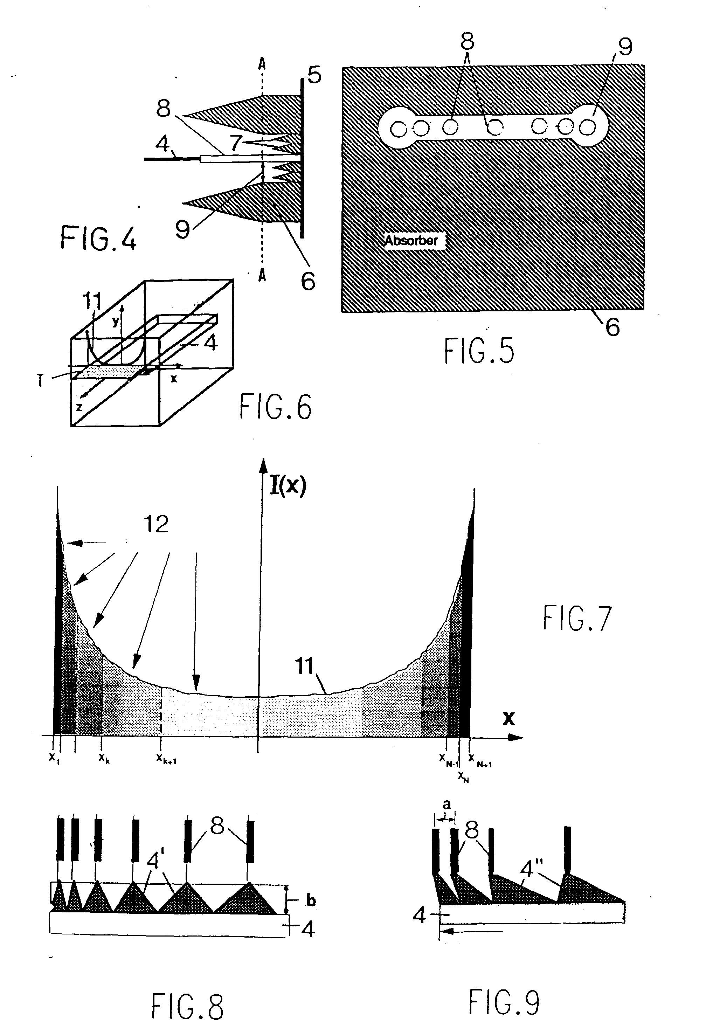

Der eingetragene Pfeil zeigt eine mit (z) bezeichnete Richtung des TEM-Wellenfeldes an, vgl. auch Fig. 6. Ein im Innenleiter fließender Strom hat in einer x-Richtung senkrecht zur Zeichenebene von Fig. 1 einen in den Fig. 6 und 7 dargestellten Verlauf (11) der Stromdichte (I(x)). Randseitig ist die Stromdichte (I(x)) größer als in der Mitte. Mit (12) sind dort Bereiche gleicher Stromdichte (I(x)) bezeichnet. Die x-Koordinaten der Grenzen dieser Bereiche (12) sind mit (x₁, xₖ, xₖ₊₁, x_{N-1}, x_{N}, x_{N+1}) bezeichnet.

In Fig. 1 ist nur 1 rohrförmiger Widerstand (8) zu erkennen. Tatsächlich sind senkrecht zur Zeichenebene mehrere rohrförmige Widerstände (8) elektrisch parallelgeschaltet, wie es aus den Fig. 8 und 9 erkennbar ist. Im Anschlußbereich an die rohrförmigen Widerstände (8) ist der Innenleiter (4) sägezahnförmig ausgebildet, wobei die Spitze jedes Sägezahnes mit einem rohrförmigen Widerstand (8) elektrisch gutleitend verbunden ist. Randseitig sind die Sägezahnspitzen enger beieinander als in der Mitte, da randseitig die Stromdichte (I(x)) größer ist als in der Mitte. Bei gleichbemessenen rohrförmigen Widerständen (8) wird somit randseitig mehr Energie in Wärme umgewandelt als in der Mitte des Innenleiters (4). Der Abstand benachbarter rohrförmiger Widerstände (8) entspricht somit dem Verlauf (11) der Stromdichte (I(x)). Die Sägezahnspitzen können dreieckförmig (4') ausgebildet sein, wie in Fig. 8 dargestellt, oder trapezförmig (4"), wie aus Fig. 9 ersichtlich. Eine Tiefe (b) der Übergangszone (4'), vgl. Fig. 8, wird einerseits durch die Größe der TEM-Wellenleiteranordnung (10) und andererseits durch die Länge der rohrförmigen Widerstände (8) bestimmt, welche wiederum von der gegebenen maximalen Eingangsleistung der TEM-Wellenleiteranordnung (10) abhängt.

Die Tiefe (b) wird begrenzt durch die maximal zulässigen Unterschied in den Pfadlängen der Wellenfronten des Stromes zwischen den Dreieck-Außenseiten und der DreieckMittelsenkrechten, welcher nicht größer als etwa λₘᵢₙ/10 sein sollte. Dabei bedeutet λₘᵢₙ die minimale TEM-Wellenlänge von z. B. 3 cm bei einer höchsten Betriebsfrequenz von 1 GHz. Benachbarte rohrförmige Widerstände (8) sollen einen lateralen Mindestabstand (a), vgl. Fig. 9, im Bereich von 0,5 cm - 1 cm haben, um eine ausreichende Ventilation zu ermöglichen.

Die rohrförmigen Widerstände (8) bestehen aus einer Mischung von leitfähigen und keramischen Stoffen; sie sind im Handel mit Leistungen bis zu 1 kW erhältlich, vgl. die eingangs genannte Literaturstelle bezüglich rohrförmiger Widerstände. Für eine Eingangsleistung der TEM-Wellenleiteranordnung (10) von 10 kW und eine maximal zulässige Oberflächentemperatur der rohrförmigen Widerstände (8) von 120 °C wurden in einem Ausführungsbeispiel 38 parallelgeschaltete, gleiche Widerstände von je 80 cm Länge, 2,5 cm Durchmesser und einer Leistung von 250 W verwendet. Die parallelgeschalteten Widerstände (8) bilden einen Gesamtwiderstand von 50 Ω, der charakteristischen Impedanz des Innenleiters (4). Der Gesamtwiderstand wird stets auf die charakteristische Impedanz des Innenleiters (4) abgestimmt, die z. B. auch 60 Ω betragen könnte. Die Länge der rohrförmigen Widerstände (8) wird durch die maximale Leistung und die Betriebsbedingungen bestimmt. Das Ende der rohrförmigen Widerstände (8) ist direkt mit der metallischen sphärischen Rückwand (5) gutleitend verbunden.

Die Hochfrequenzabsorber (6, 7) befinden sich am aufgeweiteten Ende der TEM-Wellenleiteranordnung (10); sie laufen in dessen Innenraum als 4seitige regelmäßige Pyramiden spitz zu. Die dem rohrförmigen Widerstand (8) benachbarten HF-Kurzspitzenabsorber (7) weisen zu den rohrförmigen Widerständen (8) einen Abstand auf, um deren kapazitiven Einfluß zu minimieren und die Ventilation zu gewährleisten; sie sind kürzer als die vom rohrförmigen Widerstand (8) weiter entfernten HF-Langspitzenabsorber (6). Die HF-Kurzspitzenabsorber (7) unterdrücken Reflexionen, die bei ihrem Fehlen aus den Lücken zwischen den HF-Langspitzenabsorbern (6) hervortreten würden. Mit diesen HF-Kurzspitzenabsorbern (7) ist es möglich, sehr große TEM-Wellenleiteranordnungen (10) mit Hochfrequenzabsorberspitzen von 3,75 m Länge herzustellen.

Die Abmessungen des gesamten Abschlusses aus rohrförmigen Widerständen (8) und Hochfrequenzabsorbern (6, 7) ist speziell für den Übergangsfrequenzbereich wichtig, bei dem seine Charakteristik von einem resistiven in einen absorbierenden Zustand wechselt. Der Übergangsbereich, bei dem der Hochfrequenzabsorber (6, 7) zu wirken beginnt, hängt sowohl von der Größe der TEM-Wellenleiteranordnung (10) als auch vom Abschluß selbst ab. Bei einer Standard-TEM-Wellenleiteranordnung (10) liegt dieser Übergangsbereich zwischen 50 MHz und 200 MHz.

Der TEM-Mode breitet sich in der TEM-Wellenleiteranordnung (10) als sphärische Wellenfront aus. Alle Punkte der Wellenfront haben dieselbe Distanz zur Quelle, d. h. zum Speisekeil (2). Die Phasen der momentanen Schwingung auf der Wellenfront sind alle gleich. Deshalb ist die Rückwand (5) vorzugsweise sphärisch geformt bzw. ausgebildet.

Der Innenleiter (4) und der Außenleiter (1) müssen hinter den Hochfrequenzabsorbern (6, 7) elektrisch verbunden werden. Die besten Resultate wurden erreicht, indem die Rückwand (5) direkt hinter den Hochfrequenzabsorbern (6, 7) plaziert wurde. Der Widerstandsabschluß wird damit durch die Hochfrequenzabsorber (6, 7) hindurch direkt auf die Rückwand (5) geführt und elektrisch flächig verbunden, so daß eine sehr niederinduktive Verbindung zum Außenleiter (1) der TEM-Wellenleiteranordnung (10) erreicht wird.

Die Hochfrequenzabsorber (6, 7) bestehen aus pyramidenförmig zugeschnittenem Polyurethan-Schaum. Der Schaum wird z. B. mit Graphit oder Kohlepulver versetzt, welches die Absorption der elektromagnetischen Energie bewirkt. Die verschiedenen Absorbertypen werden nicht nur durch deren Abmessungen und Form, sondern auch durch die Dichte des Kohleanteils unterschieden. Bei relativ niedrigen Frequenzen < 100 MHz ist die absorbierende Wirkung gering, und der Hochfrequenzabsorber (6, 7) verhält sich wie ein Dielektrikum. Die durch die Hochfrequenzabsorber (6, 7) geführten rohrförmigen Widerstände (8) erfahren so eine kapazitive Belastung, welche die Impedanz des Abschlusses verändert. Hochfrequenzabsorber (6, 7) mit wenig Kohleanteil haben einen niedrigeren Imaginäranteil der Dielektrizitätskonstante. Hochfrequenzabsorber (6, 7) mit einem größeren Kohleanteil haben eine bessere Absorptionswirkung bei tiefen Frequenzen. Es hat sich gezeigt, daß eine niedrigere kapazitive Wirkung der Hochfrequenzabsorber (6, 7) einer großen Absorption bei tiefen Frequenzen vorzuziehen ist.

Verwendet man Hochfrequenzabsorber (6, 7) mit geringem Kohleanteil, so wird die kapazitive Belastung des Widerstandsabschlusses verringert. Eine zusätzliche Verbesserung erreicht man mit einem Luftspalt (9), vgl. die Fig. 2 - 4, zwischen rohrförmigen Widerständen (8) und Hochfrequenzabsorbern (6, 7). Typischerweise beträgt dieser bei einer Standard-TEM-Wellenleiteranordnung (10) ca. 10 cm - 15 cm. Da am Rande des Innenleiters (4) die Stromdichte (I(x)) viel größer ist als in der Mitte, muß dort der Luftspalt (9) zusätzlich vergrößert werden, vgl. Fig. 2. Macht man den Luftspalt (9) zu groß, so muß mit erhöhten Reflexionen von der Rückwand (5) gerechnet werden. Ein Kompromiß wird erreicht, wenn der Luftspalt (9) zusätzlich mit einer Reihe von viel kürzeren, direkt an der Rückwand (5) angebrachten HF-Kurzspitzenabsorbern (7) ausgefüllt wird, vgl. Fig. 3. Damit hat man die Reflexionen bei höheren Frequenzen minimiert und die kapazitive Belastung nur unwesentlich erhöht.

Da der kapazitive Einfluß auf die Widerstandslast minimiert wurde, kann die bei einer Standard-TEM-Wellenleiteranordnung (10) verwendete Längsanpasssung der Widerstandslast an den Kapazitätsbelag der Hochfrequenzabsorber (6, 7) vernachlässigt werden. Der Widerstandsabschluß kann folglich in Längsrichtung (z) mit konstantem Widerstand ausgeführt werden. Die in Querrichtung (x) herrschende Stromdichte (I(x)) auf dem Innenleiter (4) muß aber nach wie vor berücksichtigt werden durch einen geringeren Abstand benachbarter rohrförmiger Widerstände (8) in den Randbereichen.

Fig. 4 zeigt ausschnittsweise den Anschluß des Innenleiters (4) an die Rückwand (5) über einen rohrförmigen Widerstand (8) mit 2 dem rohrförmigen Widerstand (8) benachbarten HF-Kurzspitzenabsorbern (7) und einem großen Luftspalt (9) zwischen dem rohrförmigen Widerstand (8) und einem benachbarten HF-Langspitzenabsorber (6).

Fig. 5 zeigt eine Schnittansicht längs einer Linie A - A in Fig. 4 mit Blickrichtung nach rechts. Man erkennt, daß die Abstände der rohrförmigen Widerstände (8) randseitig kleiner als in der Mitte sind.

Fig. 6 zeigt den Verlauf (11) der Stromdichte (I(x)) in dem Innenleiter (4). Eine Anpassung an die vorliegende Stromdichte (I(x)) kann entweder durch unterschiedlich bemessene Widerstände (8) in gleichem lateralem Abstand erreicht werden, deren Belastbarkeit der unterschiedlichen Stromdichte (I(x)) entspricht, oder vorzugsweise durch gleich bemessene rohrförmigen Widerstände (8) in einem Abstand, welcher dem Verlauf (11) der Stromdichte (I(x)) entspricht. Aus der Aufteilung der Stromverteilung in Bereiche (12) gleicher Stromdichte, vgl. Fig. 7, ergibt sich die Plazierung der rohrförmigen Widerstände (8).

Es versteht sich, daß anstelle von pyramidenförmigen Hochfrequenzabsorbern (6, 7) auch anders geformte, z. B. kegelförmige Hochfrequenzabsorber ohne Spitzen verwendet werden können. Wichtig ist, daß die rohrförmigen Widerstände (8) gut ihre Verlustwärme abführen können.

Der Innenleiter (4) kann anstatt plattenförmig auch drahtförmig ausgebildet sein.

### BEZEICHNUNGSLISTE

- 1: Außenleiter
- 2: Speisekeil von 10
- 3: Koaxialkabel
- 4: Innenleiter, Scheidewand
- 4': dreieckförmige Übergangselemente, sägezahnförmige Übergangszone von 4
- 4'': trapezförmige Übergangselemente, sägezahnförmige Übergangszone von 4
- 5: Rückwand von 10
- 6: Hochfrequenzabsorber, HF-Langspitzenabsorber
- 7: Hochfrequenzabsorber, HF-Kurzspitzenabsorber
- 8: rohrförmige Widerstände
- 9: Luftspalt
- 10: TEM-Wellenleiteranordnung
- 11: Stromdichtekurve
- 12: Bereiche gleicher Stromdichte

- a: lateraler Mindestabstand von 8 von 4' und 4''
- b: Tiefe der Übergangszone von 4'
- I(x): Stromdichte
- T: Übergangsbereich
- x, y, z: Koordinatenrichtungen

## Patentansprüche

1. TEM-Wellenleiteranordnung (10)
a) mit mindestens einem Außenleiter (1),
b) mindestens einem Innenleiter (4),
c) mit langen Hochfrequenzabsorbern oder HF-Langspitzenabsorbern (6) zur Absorption feldgebundener Energie, die sich von einer Rückwand (5) der TEM-Wellenleiteranordnung (10) über einen in seiner Länge vorgebbaren Übergangsbereich (T) ins Innere der TEM-Wellenleiteranordnung (10) erstrecken, und
d) mit elektrischen Widerständen (8), die den Innenleiter (4) mit der Rückwand (5) der TEM-Wellenleiteranordnung (10) elektrisch verbinden, zur Absorption leitergebundener Energie von TEM-Wellen,
e) wobei die langen Hochfrequenzabsorber (6) von diesen Widerständen (8) einen vorgebbaren Abstand aufweisen.
dadurch gekennzeichnet,
f) daß die elektrischen Widerstände (8) rohrförmig sind und
g) dass kurze Hochfrequenzabsorber oder HF-Kurzspitzenabsorber (7) vorhanden sind, welche kürzer als die HF-Langspitzenabsorber (6) sind, wobei die HF-Kurzspitzenabsorber (7) zwischen den Widerständen (8) und den HF-Langspitzenabsorbern (6) angeordnet sind.

2. TEM-Wellenleiteranordnung (10) nach Anspruch 1, dadurch gekennzeichnet, daß die rohrförmigen Widerstände (8) zu benachbarten langen oder HF-Langspitzenabsorbern (6) einen Mindestabstand im Bereich von 10 cm - 15 cm aufweisen.

3. TEM-Wellenleiteranordnung (10) nach Anspruch 1, dadurch gekennzeichnet, daß die HF-Langspitzenabsorber (6) auf der übrigen Rückwand (5) aufgebracht sind.

4. TEM-Wellenleiteranordnung (10) nach einem der vorhergehenden Ansprüche, dadurch gekennzeichnet, daß der gegenseitige laterale Abstand der rohrförmigen Widerstände (8) dem Verlauf (11) einer Stromdichte (I(x)) im Innenleiter (4) entspricht, derart, daß an Orten mit einer größeren Stromdichte (I(x)) die rohrförmigen Widerstände (8) dichter beieinander angeordnet sind als an Orten mit kleinerer Stromdichte (I(x)).

5. TEM-Wellenleiteranordnung (10) nach einem der Ansprüche 1 bis 3, dadurch gekennzeichnet, daß die Belastbarkeit der rohrförmigen Widerstände (8) dem Verlauf (11) einer Stromdichte (I(x)) im Innenleiter (4) entspricht, derart, daß in Bereichen (12) mit größerer Stromdichte (I(x)) die rohrförmigen Widerstände (8) stärker belastbar sind als in Bereichen (12) mit geringerer Stromdichte (I(x)).

6. TEM-Wellenleiteranordnung (10) nach einem der vorhergehenden Ansprüche, dadurch gekennzeichnet, daß die rohrförmigen Widerstände (8) unmittelbar flächig mit der Rückwand (5) elektrisch verbunden sind.

## Claims

1. TEM waveguide arrangement (10)
a) having at least one outer conductor (1), and
b) at least one inner conductor (4),
c) having long radio-frequency absorbers or RF long-point absorbers (6) for absorbing field-bound energy, which extend from a rear wall (5) of the TEM waveguide arrangement (10) into the interior of the TEM waveguide arrangement (10) via a transition region (T) of prescribable length, and
d) having electrical resistors (8) which electrically connect the inner conductor (4) to the rear wall (5) of the TEM waveguide arrangement (10), for absorbing conductor-bound energy of TEM waves,
characterized in that
e) the long radio-frequency absorbers (6) being at a prescribable distance from said resistors (8).
f) the electrical resistors (8) are tubular and
g) in that short radio-frequency absorbers or RF short-point absorbers (7) are present which are shorter than the RF long-point absorbers (6), the RF short-point absorbers (7) being arranged between the resistors (8) and the RF long-point absorbers (6),

2. TEM waveguide arrangement (10) according to Claim 1, characterized in that the tubular resistors (8) have a minimum spacing from the adjacent long or RF long-point absorbers (6) in the range of 10 cm - 15 cm.

3. TEM waveguide arrangement (10) according to Claim 1, characterized in that RF long-point absorbers (6) are mounted on the remaining rear wall (5).

4. TEM waveguide arrangement (10) according to one of the preceding claims, characterized in that the mutual lateral spacing of the tubular resistors (8) corresponds to the course (11) of a current density (I(x)) in the inner conductor (4) in such a way that the tubular resistors (8) are arranged closer to one another at locations with a higher current density (I(x)) in the inner conductor (4) in such a way that the tubular resistors (8) are arranged closer to one another at locations with a higher current density (I(x)) than at locations with a lower current density (I(x)).

5. TEM waveguide arrangement (10) according to one of Claims 1 to 3, characterized in that the loadability of the tubular resistors (8) corresponds to the course (11) of a current density (I(x)) in the inner conductor (4) in such a way that the tubular resistors (8) can be loaded more heavily in regions (12) of higher current density (I(x)) than in regions (12) of lower current density (I(x)).

6. TEM waveguide arrangement (10) according to one of the preceding claims, characterized in that the tubular resistors (8) are directly connected electrically to the rear wall (5) in a planar fashion.

## Revendications

1. Dispositif guide d'ondes de type TEM (10)
a) avec au moins un conducteur extérieur (1),
b) au moins un conducteur intérieur (4),
c) avec des absorbeurs à haute fréquence longs ou absorbeurs HF à pointes longues (6) destinés à absorber l'énergie liée au champ qui s'étendent d'une paroi arrière (5) du dispositif guide d'ondes de type TEM (10) en passant par une zone de transition (T) dont la longueur peut être prédéfinie à l'intérieur du dispositif guide d'ondes de type TEM (10), et
d) avec des résistances électriques (8) qui relient électriquement le conducteur intérieur (4) à la paroi arrière (5) du dispositif guide d'ondes de type TEM (10) pour absorber l'énergie liée au conducteur des ondes de type TEM,
e) les absorbeurs à haute fréquence longs (6) présentant un écart donné par rapport à ces résistances (8),
caractérisé par le fait
f) que les résistances électriques (8) sont tubulaires et
g) qu'il existe des absorbeurs à haute fréquence courts ou absorbeurs HF à pointes courtes (7) qui sont plus courts que les absorbeurs HF à pointes longues (6), les absorbeurs HF à pointes courtes (7) étant disposés entre les résistances (8) et les absorbeurs HF à pointes longues (6).

2. Dispositif guide d'ondes de type TEM (10) selon la revendication 1, caractérisé par le fait que les résistances tubulaires (8) présentent un écart minimum de 10 cm à 15 cm par rapport aux absorbeurs HF longs ou à pointes longues (6) voisins.

3. Dispositif guide d'ondes de type TEM (10) selon la revendication 1, caractérisé par le fait que les absorbeurs HF à pointes longues (6) sont montés sur le reste de la paroi arrière (5).

4. Dispositif guide d'ondes de type TEM (10) selon l'une des revendications précédentes, caractérisé par le fait que l'écart latéral réciproque entre les résistances tubulaires (8) correspond à la courbe (11) d'une densité du courant (I(x)) dans le conducteur intérieur (4), de telle manière que les résistances tubulaires (8) soient disposées plus près les unes des autres aux endroits où la densité du courant (I(x)) est plus élevée qu'aux endroits où la densité du courant (I(x)) est plus faible.

5. Dispositif guide d'ondes de type TEM (10) selon l'une des revendications 1 à 3, caractérisé par le fait que la charge admissible des résistances tubulaires (8) correspond à la courbe (11) d'une densité du courant (I(x)) dans le conducteur intérieur (4), de telle manière que les résistances tubulaires (8) dans les zones (12) où la densité du courant (I(x)) est plus élevée aient une charge admissible supérieure à celle dans les zones (12) où la densité du courant (I(x)) est plus faible.

6. Dispositif guide d'ondes de type TEM (10) selon l'une des revendications précédentes, caractérisé par le fait que les résistances tubulaires (8) sont reliées électriquement à la paroi arrière (5) de manière directe sur un seul plan.
